(19) Europäisches Patentamt
European Patent Office
Office européen des brevets

(11) **EP 2 999 015 A1**

(12) **EUROPEAN PATENT APPLICATION**

(43) Date of publication:
**23.03.2016 Bulletin 2016/12**

(51) Int Cl.:
**H01L 33/50** (2010.01)  **C09K 11/77** (2006.01)

(21) Application number: **15182329.1**

(22) Date of filing: **25.08.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **18.09.2014 JP 2014190378**

(71) Applicant: **Kabushiki Kaisha Toshiba
Tokyo 105-8001 (JP)**

(72) Inventors:
• **Mitsuishi, Iwao
Tokyo, 105-8001 (JP)**
• **Kato, Masahiro
Tokyo, 105-8001 (JP)**
• **Hattori, Yasushi
Tokyo, 105-8001 (JP)**
• **Fukuda, Yumi
Tokyo, 105-8001 (JP)**
• **Albessard, Keiko
Tokyo, 105-8001 (JP)**

(74) Representative: **Hoffmann Eitle
Patent- und Rechtsanwälte PartmbB
Arabellastraße 30
81925 München (DE)**

(54) **PHOSPHOR, LIGHT-EMITTING DEVICE, AND METHOD FOR PRODUCING PHOSPHOR**

(57)    An embodiment is to provide a phosphor that has favorable temperature characteristics, that can emit yellow light with a wide half-width emission spectrum, and that has high quantum efficiency. The phosphor emits yellow light when excited with light having a luminescence peak in a wavelength range of 250 to 500 nm, and has a crystal structure that is substantially identical to the crystal structure of $Sr_2Al_3Si_7ON_{13}$. The half-width of a peak at a diffraction peak position $2\theta$ in a range of 35.2 to 35.6, detected in X-ray diffraction of the phosphor according to Bragg-Brendano method using a Cu-K$\alpha$ line, is 0.10° or less.

FIG. 1A

FIG. 1B

FIG. 1C

**Description**

BACKGROUND

Field of the Invention

An embodiment of the present invention relates to a phosphor, a light-emitting device, and a method for producing the phosphor.

Description of the Related Art

A white light-emitting device comprises a combination of, for example, a phosphor that emits red light by excitation with blue light, a phosphor that emits green light by excitation with blue light, and a blue LED. In contrast, use of a phosphor that emits yellow light by excitation with blue light enables a white light-emitting device to be formed using fewer kinds of phosphors. Examples of such yellow light-emitting phosphors which are known include a Eu-activated orthosilicate phosphor. Such yellow phosphors having higher practicality have been desired. Improvements in, e.g., their temperature characteristics, quantum efficiencies, or emission spectrum half-widths have been examined.

BRIEF DESCRIPTION OF THE DRAWINGS

FIGS. 1A to 1C are views illustrating the crystal structure of $Sr_2Al_3Si_7ON_{13}$;
FIG. 2 is a schematic view illustrating the configuration of a light-emitting device according to an embodiment;
FIG. 3 is a schematic view illustrating the configuration of a light-emitting device according to another embodiment;
FIG. 4 shows the X-ray diffraction pattern of a phosphor of Example 1;
FIG. 5 is a view showing the emission spectrum of the phosphor of Example 1;
FIG. 6 is a view showing the temperature characteristics of the phosphor of Example 1; and
FIG. 7 is a view showing a relationship between a half-width in X-ray diffraction and a relative luminous efficiency.

DETAILED DESCRIPTION

A phosphor according to an embodiment of the present embodiment exhibits a luminescence peak in a wavelength range of 500 to 600 nm when excited with light having a luminescence peak within a wavelength range of 250 to 500 nm,
wherein said phosphor is represented by the following formula (1):

$$((Sr_pM_{1-p})_{1-x}Ce_x)_{2y}Al_zSi_{10-z}O_uN_w \quad (1)$$

wherein M is at least one of alkali metals or alkaline earth metals; and

$$0 \leq p \leq 1,$$

$$0 < x \leq 0.2,$$

$$0.8 \leq y \leq 1.1,$$

$$2 \leq z \leq 3.5,$$

$$0 < u \leq 1,$$

$$1.8 \leq z - u,$$

and

$$13 \leq u + w \leq 15$$

are satisfied; and
a half-width at a diffraction peak position 2θ of 35.0 to 35.6°, detected in X-ray diffraction of the phosphor by Bragg-Brendano method using a Cu-K$\alpha$ line, is 0.10° or less.

Embodiments will now be explained with reference to the accompanying drawings.

A phosphor according to an embodiment exhibits a luminescence peak in a wavelength range of 500 to 600 nm when excited with light having a luminescence peak within a wavelength range of 250 to 500 nm, and is therefore a phosphor that can emit light in the region from yellow-green to orange. The phosphor mainly emits light in the yellow region. Therefore, hereinafter, the phosphor according to the present embodiment may be referred to as a yellow light-emitting phosphor. Such a phosphor comprises a host crystal having a crystal structure that is substantially identical to the crystal structure of $Sr_2Al_3Si_7ON_{13}$, and the host crystal is activated with a luminescence center element such as Ce. The composition of the yellow light-emitting phosphor according to the present embodiment is represented by the following formula (1):

$$((Sr_pM_{1-p})_{1-x}Ce_x)_{2y}Al_zSi_{10-z}O_uN_w \quad (1)$$

wherein M is at least one of alkali metals or alkaline earth metals; and

$$0 \leq p \leq 1,$$

$$0 < x \leq 0.2,$$

$$0.8 \leq y \leq 1.1,$$

$$2 \leq z \leq 3.5,$$

$$0 < u \leq 1,$$

$$1.8 \leq z - u,$$

and

$$13 \leq u + w \leq 15$$

are satisfied.

As shown in the formula (1) described above, some of metal elements forming a host crystal are substituted by a luminescence center element Ce. M is at least one of alkali metals or alkaline earth metals, preferably at least one selected from the group consisting of Ba, Sr, Ca, Mg, Li, Na, and K, more preferably at least one selected from Ba, Ca, and Mg. There may be a case in which p of 1 is desirable for optimizing the luminescence properties of the phosphor. However, even in such a case, there is a case in which metals other than Sr and Ce are contained as unavoidable impurities. In general, in such a case, the effects of the present embodiment are sufficiently exhibited. Ce functions as a luminescence center element. In addition to Ce, an element selected from the group consisting of Tb, Eu, and Mn can be used in combination as the luminescence center element.

A case in which Ce is 0.1 mol% or more of the total of Sr, M, and Ce can result in sufficient luminous efficiency. It is unnecessary to contain Sr and M (x = 1); however, when x is less than 0.5, reduction in luminous probability (concentration quenching) can be suppressed as much as possible. Accordingly, x is preferably 0.001 or more and 0.5 or less. The containing of the luminescence center element Ce allows the phosphor according to the present embodiment to emit light in the yellow region, i.e., to emit light having a peak in a wavelength range of 500 to 600 nm when excited with light having a peak in a wavelength range of 250 to 500 nm. Desired properties are not impaired even when some of Ce is substituted by another metal element like unavoidable impurities. Examples of such unavoidable impurities include Tb, Eu, Mn, and the like. Specifically, the percentage of the unavoidable impurities to the total of Ce and the unavoidable impurities is preferably 15 mol% or less, more preferably 10 mol% or less.

In order to reduce crystal defects to prevent efficiency from decreasing, y is allowed to be 0.8 or more, preferably 0.85 or more. In contrast, for preventing luminous efficiency from decreasing due to the precipitation of an excessive alkaline earth metal as a heterogenous phase, y of 1.1 or less is needed, and it is preferable that y is 1.06 or more. Accordingly, $0.8 \leq y \leq 1.1$ is needed, and $0.85 \leq y \leq 1.06$ is preferable.

For preventing luminescence properties from deteriorating due to the precipitation of excessive Si as a heterogenous phase, z of 2 or more is needed, and z of 2.5 or more is preferable. In contrast, for preventing luminescence properties from deteriorating due to the precipitation of excessive Al as a heterogenous phase in z of more than 3.5, z of 3.5 or less is needed, and z of 3.3 or less is preferable. Accordingly, $2.0 \leq z \leq 3.5$ is needed, and $2.2 \leq z \leq 3.0$ is preferable.

Excessive O may result in decreased covalency in a crystal to increase crystal defects, leading to the shorter wavelength of emitted light, deteriorated luminous efficiency, or degraded temperature characteristics. Thus, for inhibiting the deterioration of luminous efficiency and the shortening of the wavelength of emitted light due to increase in crystal defects, u of 1 or less is needed, and u of 0.8 or less is preferable. In contrast, in order to maintain a desired crystal structure and to appropriately maintain the wavelength of an emission spectrum, u is preferably allowed to be 0.001 or more. Accordingly, $u \leq 1$ is needed, and $0.001 \leq u \leq 0.8$ is preferable.

Because the value of u + w corresponds to the proportion of negative ions in a crystal, the value of u + w in a specific range is needed for appropriately maintaining the balance of electric charges in the crystal to allow the structure of the crystal to be a desired structure. To maintain the desired crystal structure in the phosphor according to the embodiment and to inhibiting a heterogenous phase from being generated when the phosphor is produced, a value of z - u of 1.8 or more is needed and is preferably allowed to be 1.9 or more. For the same reason, $13 \leq u + w \leq 15$ is needed, and $13.2 \leq u + w \leq 14.2$ is preferable.

The phosphor according to the present embodiment includes all of the preferred conditions mentioned above and is therefore capable of emitting yellow light with a wide half-width emission spectrum with a high degree of efficiency when excited with light having a luminescence peak in a wavelength range of 250 to 500 nm. A light-emitting element using the phosphor enables white light excellent in color rendering properties. Moreover, the yellow light-emitting phosphor according to the present embodiment has a feature in that it has favorable temperature characteristics.

The yellow light-emitting phosphor of the present embodiment is based on an inorganic compound having a crystal structure that is substantially identical to the crystal structure of $Sr_2Al_3Si_7ON_{13}$, in which some of elements Sr forming the compound are substituted by luminescence center ions Ce. It may be considered that the phosphor is based on $Sr_2Al_3Si_7ON_{13}$, in which Si and Ai are replaced with each other, or O and N are replaced with each other, and another metal element such as Ce forms a solid solution. In the present embodiment, such a crystal is referred to as a $Sr_2Al_3Si_7ON_{13}$-based crystal. Such replacement with an atom or the like may result in slight change of a crystal structure but rarely results in change of an atom position to such a large extent that a chemical bond between skeleton atoms is cleaved. The atom position is determined by the crystal structure, the site occupied by the atom, and its coordinate.

The effect of the present embodiment can be exerted as long as the basic crystal structure of the yellow light-emitting phosphor of the present embodiment is not changed. The phosphor according to the present embodiment may vary from $Sr_2Al_3Si_7ON_{13}$ in lattice constants and in the chemical bond lengths of Sr (or M or Ce)-N and Sr (or M or Ce)-O (hereinafter simply referred to as distances between near neighbor atoms of M-N and M-O). The variations within ranges of $\pm 15\%$ of the lattice constants of $Sr_2Al_3Si_7ON_{13}$ and chemical bond lengths (Sr-N and Sr-O) in $Sr_2Al_3Si_7ON_{13}$ lead to a definition that the crystal structure is unchanged. The lattice constants can be determined by X-ray diffraction or neutron beam diffraction, and the chemical bond lengths (distances between near neighbor atoms) of M-N and M-O can be calculated from the atomic coordinates.

The $Sr_2Al_3Si_7ON_{13}$ crystal belongs to a monoclinic system, particularly to an orthorhombic system, with lattice constants of a = 11.7 Å, b = 21.4 Å, and c = 4.96 Å. The crystal belongs to the space group Pna21 (which is the 33rd space group listed in International Tables for Crystallography, Volume A: Space-group symmetry, Edited by T. Hahn, Springer (Netherlands)). The chemical bond lengths (Sr-N and Sr-O) in $Sr_2Al_3Si_7ON_{13}$ can be calculated from the atomic coordinates listed in Table 1 below.

Table 1

|  | Site | Occupancy rate | x | y | z |
|---|---|---|---|---|---|
| Sri | 4a | 1 | 0.2786 | 0.49060 (11) | 0.5284 (14) |
| Sr2 | 4a | 1 | 0.3552 (3) | 0.69839 (12) | 0.048 (2) |
| Si/Al1 | 4a | 1 | 0.3582 (9) | 0.2769 (3) | 0.070 (3) |
| Si/Al2 | 4a | 1 | 0.5782 (9) | 0.7996 (4) | 0.047 (5) |
| Si/Al3 | 4a | 1 | 0.5563 (8) | 0.4672 (3) | 0.543 (5) |
| Si/Al4 | 4a | 1 | 0.4724 (8) | 0.6092 (3) | 0.556 (4) |
| Si/Al5 | 4a | 1 | 0.1910 (7) | 0.6397 (3) | 0.535 (4) |
| Si/Al6 | 4a | 1 | 0.0061 (8) | 0.5438 (3) | 0.546 (4) |
| Si/Al7 | 4a | 1 | 0.1625 (9) | 0.5661 (3) | 0.038 (4) |
| Si/Al8 | 4a | 1 | 0.3937 (8) | 0.3469 (3) | 0.547 (4) |
| Si/Al9 | 4a | 1 | 0.1552 (18) | 0.3483 (8) | 0.318 (3) |
| Si/Al10 | 4a | 1 | 0.1525 (14) | 0.3492 (6) | 0.813 (2) |
| O/N1 | 4a | 1 | 0.436 (2) | 0.8164 (10) | 0.061 (11) |
| O/N2 | 4a | 1 | 0.699 (2) | 0.4692 (10) | 0.513 (10) |
| O/N3 | 4a | 1 | 0.334 (2) | 0.6355 (10) | 0.511 (9) |
| O/N4 | 4a | 1 | 0.213 (2) | 0.2980 (11) | 0.056 (12) |
| O/N5 | 4a | 1 | 0.256 (2) | 0.3750 (10) | 0.563(9) |
| O/N6 | 4a | 1 | 0.894 (2) | 0.6002 (12) | 0.549 (14) |
| O/N7 | 4a | 1 | 0.358 (3) | 0.2062 (12) | 0.893 (6) |
| O/N8 | 4a | 1 | 0.508 (2) | 0.4677 (12) | 0.885 (6) |
| O/N9 | 4a | 1 | 0.398 (2) | 0.2727 (12) | 0.392 (6) |
| O/N10 | 4a | 1 | 0.430 (3) | 0.3336 (15) | 0.896 (7) |
| O/N11 | 4a | 1 | 0.942 (3) | 0.4814 (15) | 0.371 (8) |
| O/N12 | 4a | 1 | 0.662 (2) | 0.8571 (12) | 0.893 (6) |
| O/N13 | 4a | 1 | 0.128 (3) | 0.5743 (15) | 0.381 (7) |
| O/N14 | 4a | 1 | 0.495 (3) | 0.3982 (13) | 0.383 (6) |

The yellow light-emitting phosphor of the present embodiment needs to have such a crystal structure. When the chemical bond lengths are changed beyond the above ranges, the chemical bonds are cleaved to form another crystal, leading to a failure to obtain the effect of the present embodiment.

The yellow light-emitting phosphor of the present embodiment is based on an inorganic compound having a crystal structure that is substantially identical to the crystal structure of $Sr_2Al_3Si_7ON_{13}$, in which some of elements M forming the compound are substituted by luminescence center ions Ce, and the composition of each element is specified into a predetermined limit, and the half-width of a certain X-ray diffraction peak is narrow. In this case, preferred properties of high efficiency and excellent temperature characteristics are exhibited.

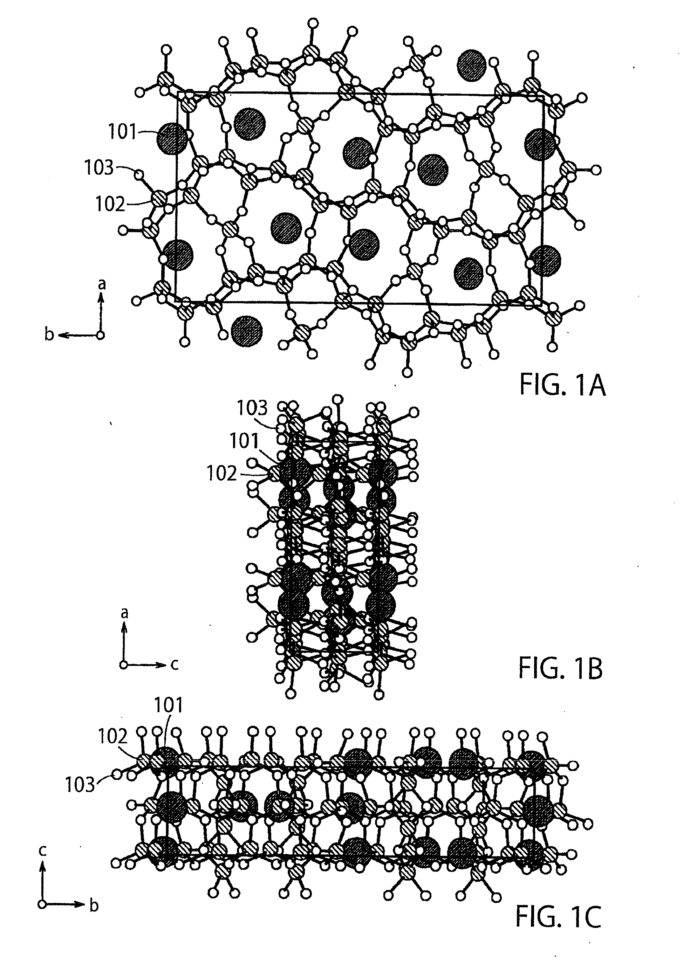

The crystal structure of $Sr_2Al_3Si_7ON_{13}$ based on the atomic coordinates listed in Table 1 is illustrated in FIG. 1. FIG. 1A is a projection view along the c-axis direction, FIG. 1B is a projection view along the b-axis direction, and FIG. 1C is a projection view along the a-axis direction. In FIG. 1, reference numeral 101 denotes a Sr atom, which is surrounded by a Si or Al atom 102 and an O or N atom 103. The crystal of $Sr_2Al_3Si_7ON_{13}$ can be identified by X-ray diffraction (XRD) or neutron diffraction.

The phosphor of the present embodiment has peaks at specific diffraction angles ($2\theta$) in the X-ray diffraction pattern according to Bragg-Brendano method using a Cu-K$\alpha$ line. In other words, the phosphor has at least ten peaks at diffraction angles (2θ) of 15.05 to 15.25°, 23.03 to 23.23°, 24.87 to 25.07°, 25.70 to 25.90°, 25.97 to 26.17°, 29.33 to 29.53°, 30.92 to 31.12°, 31.65 to 31.85°, 33.02 to 33.22°, 33.59 to 33.79°, 34.35 to 34.55°, 35.20 to 35.60°, 36.02 to 36.22°, 36.55 to 36.75°, 37.20 to 37.40°, and 56.50 to 56.70°.

The yellow light-emitting phosphor according to the present embodiment can be produced by an arbitrary method. Specifically, the phosphor according to the embodiment of the present invention can be produced by mixing raw material powders containing each element and by firing the mixture. In this case, it is preferable to use specific raw materials and to control firing atmosphere.

A Sr-containing raw material can be selected from nitrides, silicides, carbides, carbonates, hydroxides, and oxides of Sr. A M-containing raw material can be selected from nitrides, silicides, carbides, carbonates, hydroxides, and oxides of M. An Al-containing raw material can be selected from nitrides, oxides, and carbides of Al, and a Si-containing raw material can be selected from nitrides, oxides, and carbides of Si. A Ce-containing raw material can be selected from chlorides, oxides, nitrides, and carbonates of Ce.

Nitrogen can be given from a nitride raw material or from atmosphere containing nitrogen by firing in the atmosphere, and oxygen can be given from an oxide raw material or from a surface oxidation coating of a nitride raw material.

For example, $Sr_3N_2$, AlN, $Si_3N_4$, $Al_2O_3$ and AlN, and $CeO_2$ or $CeCl_3$ are mixed in preparation composition which may form composition of interest. $Sr_2N$, SrN, $SrSi_2$, or the like, or a mixture thereof may be used instead of $Sr_3N_2$. For obtaining a uniform mixed powder, it is desirable to perform dry mixing of the raw material powders in order of increasing mass.

The raw materials can be mixed, for example, using a mortar in a glove box. The mixed powders are encased in a crucible and fired under predetermined conditions, to thereby obtain the phosphor according to the present embodiment. The material of the crucible is not particularly limited but can be selected from boron nitride, silicon nitride, silicon carbide, carbon, aluminum nitride, sialon, aluminum oxide, molybdenum, tungsten, and the like.

It is desirable to fire the mixed powders at a pressure that is not less than atmospheric pressure. The firing at the pressure that is not less than atmospheric pressure is advantageous in view of inhibiting silicon nitride from decomposing. For suppressing the decomposition of silicon nitride at high temperature, a pressure (absolute pressure) of 5 atmospheres or more is preferred, and a firing temperature ranging from 1500 to 2000°C is preferable. Such conditions allow a sintered body of interest to be obtained without causing trouble such as sublimation of a material or a product. When there are a plurality of firing steps as mentioned below, it is preferable to perform all of the firing steps under a pressurization condition. A firing temperature of 1800 to 2000°C is more preferred.

When the phosphor according to the present embodiment is produced, annealing is preferred for cooling the fired product after the firing. In particular, the phosphor having excellent properties can be produced by controlling a cooling rate from the maximum temperature of the firing preferably to a reduction of 300°C, more preferably to a reduction of 600°C. More specifically, it is preferable to control the cooling rate from the firing temperature to cooling to 1300°C, more preferably from the firing temperature to cooling to 1200°C. The cooling rate is preferably 10°C/min or less, more preferably 5°C/min or less. In contrast, a decrease in the cooling rate may result in deterioration of production efficiency, and the cooling rate is preferably 1°C/min or more, more preferably 2°C/min or more. When there are a plurality of firing steps as mentioned below, it is preferable to control cooling rates in all of the firing steps.

The firing atmosphere preferably has a low oxygen content in every firing step. This is because oxidation of raw materials such as AlN is avoided. Specifically, firing in nitrogen atmosphere, high-pressure nitrogen atmosphere, or deoxidation atmosphere is desired. The atmosphere may contain up to around 50 vol% of hydrogen molecules.

It is preferable to perform firing at the above-described temperature for 0.5 to 10 hours, to then take a fired product out of the crucible to crush the fired product, and to re-fire the crushed product under the same conditions. A series of such steps of taking-out, crushing, and firing is repeated around 0 to 10 times, thereby resulting in advantages that the fusion of crystal grains hardly occurs and that it is easy to generate a powder with a uniform composition and crystal structure.

After the firing, as needed, post-treatment such as cleaning is performed to obtain a phosphor according to an embodiment. For example, pure water, an acid, or the like can be used in the cleaning. Examples of the acid that can be used include inorganic acids such as sulfuric acid, nitric acid, hydrochloric acid, and hydrofluoric acid; organic acids such as formic acid, acetic acid, and oxalic acid; mixed acids thereof; and the like.

Before or after acid cleaning, post-annealing treatment may be performed as needed. The order of the post-annealing treatment and the acid cleaning can be appropriately changed depending on an objective. The post-annealing treatment can be performed, for example, in reducing atmosphere containing nitrogen and hydrogen. Crystallinity and luminous efficiency are improved by such post-annealing treatment.

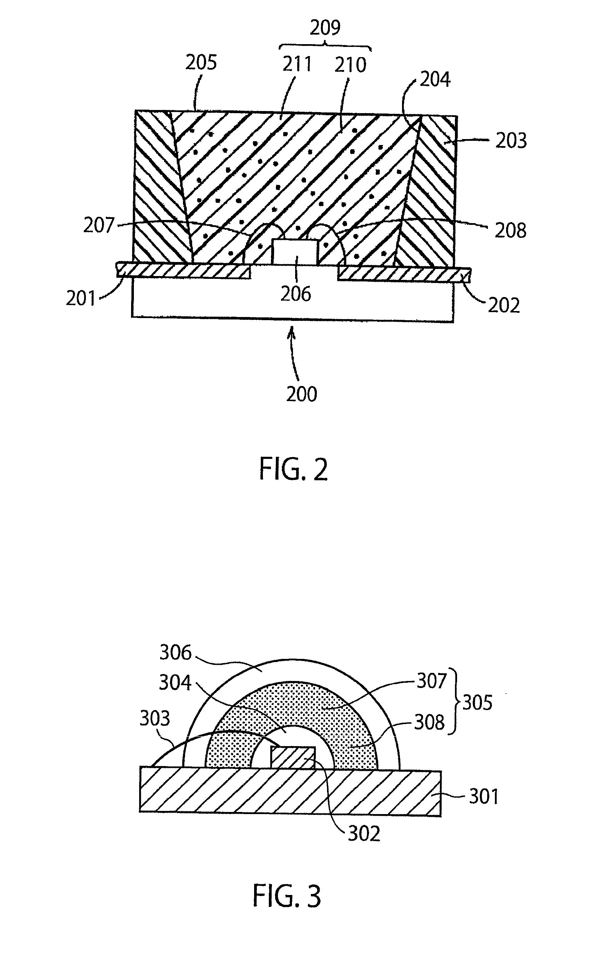

A light-emitting device according to an embodiment comprises: a fluorescence light-emitting layer containing the above-described phosphor; and a light-emitting element for exciting the above-described phosphor. FIG. 2 is a schematic view illustrating the configuration of the light-emitting device according to the embodiment.

In the light-emitting device illustrated in FIG. 2, leads 201 and 202, and a package cup 203 are placed on a substrate 200. The substrate 200 and the package cup 203 are resinous. The package cup 203 has a recess 205 of which the top is larger than the bottom. The side of the recess functions as a reflecting surface 204.

A light-emitting element 206 is mounted, with an Ag paste or the like, on the center of the generally circular bottom surface of the recess 205. The light-emitting element 206 that can be used emits light having a luminescence peak in a wavelength range of 400 to 500 nm. Examples of the light-emitting element 206 include a light-emitting diode, a laser diode, and the like. Specific examples of the light-emitting element 206 include, but are not limited to, semiconductor light-emitting elements such as GaN-based semiconductor light-emitting elements; and the like.

The p-electrode and n-electrode (not illustrated) of the light-emitting element 206 are connected, through bonding wires 207 and 208 comprising Au or the like, to the lead 201 and the lead 202, respectively. The arrangement of the leads 201 and 202 can be appropriately changed.

As the light-emitting element 206, a flip-chip-type light-emitting element including an n-type electrode and a p-type electrode on the same surface can also be used. In such a case, problems caused by a wire, such as the disconnection and peeling of the wire, and the absorption of light into the wire, are solved to provide a semiconductor light-emitting device with high reliability and high luminance. The following structure can also be made using a light-emitting element comprising an n-type substrate. An n-electrode is formed on the back surface of the n-type substrate of the light-emitting element, and a p-electrode is formed on the top surface of a p-type semiconductor layer layered on the substrate. The n-electrode is mounted on a lead, and the p-electrode is connected to the other lead through a wire.

A fluorescence light-emitting layer 209 containing a phosphor 210 according to an embodiment is placed in the recess 205 of the package cup 203. In the fluorescence light-emitting layer 209, the phosphor 210 in an amount of 5 to 60 mass% is contained, for example, in a resin layer 211 comprising silicone resin. As described above, the phosphor according to the present embodiment contains $Sr_2Al_3Si_7ON_{13}$ as a host crystal, and such an oxynitride has high covalency. Therefore, the phosphor according to the present embodiment is hydrophobic and has excellent compatibility with resins. Accordingly, scattering on the interface between the resin layer and the phosphor is markedly suppressed to improve light extraction efficiency.

The yellow light-emitting phosphor according to the present embodiment has favorable temperature characteristics and can emit yellow light with a wide half-width emission spectrum with high efficiency. A white light-emitting device having excellent luminescence properties is provided by combining the yellow light-emitting phosphor with a light-emitting element that emits light having a luminescence peak in a wavelength range of 400 to 500 nm.

The size and kind of the light-emitting element 206 as well as the dimension and shape of the recess 205 can be appropriately changed.

The light-emitting device according to the embodiment is not limited to such package-cup-type light-emitting devices as illustrated in FIG. 2 but can be appropriately changed. Specifically, the phosphor of the embodiment can also be applied to a bullet-type LED or a surface-mount-type LED, to obtain a similar effect.

FIG. 3 illustrates a schematic view illustrating the configuration of a light-emitting device according to another embodiment. In the light-emitting device illustrated in the figure, a p-electrode and an n-electrode (not illustrated) are formed in a predetermined region in an insulating substrate 301 with heat radiation characteristics, and a light-emitting element 302 is placed thereon. The material of the insulating substrate with heat radiation characteristics may be, for example, AIN.

One electrode in the light-emitting element 302 is disposed on the bottom surface of the light-emitting element 302 and is electrically connected to the n-electrode of the insulating substrate 301 with heat radiation characteristics. The other electrode in the light-emitting element 302 is connected, through a gold wire 303, to the p-electrode (not illustrated) on the insulating substrate 301 with heat radiation characteristics. As the light-emitting element 302, a light-emitting diode that emits light having a luminescence peak in a wavelength range of 400 to 500 nm is used.

An internal transparent resin layer 304 having a dome shape, a fluorescence light-emitting layer 305, and an external transparent resin layer 306 are sequentially formed on the light-emitting element 302. The internal transparent resin layer 304 and the external transparent resin layer 306 can be form with, for example, silicone or the like. In the fluorescence light-emitting layer 305, for example, a yellow light-emitting phosphor 307 of the present embodiment is contained in a resin layer 308 comprising silicone resin.

In the light-emitting device illustrated in FIG. 3, the fluorescence light-emitting layer 305 comprising the yellow light-emitting phosphor according to the present embodiment can be easily produced by adopting a technique such as vacuum printing or drop-coating from a dispenser. Moreover, since such a fluorescence light-emitting layer 305 is positioned by the internal transparent resin layer 304 and the external transparent resin layer 306, an effect of improving the extraction efficiency is obtained.

The fluorescence light-emitting layer of the light-emitting device according to the present embodiment may contain a phosphor that emits green light by excitation with blue light and a phosphor that emits red light by excitation with blue light as well as the yellow light-emitting phosphor of the present embodiment. In such a case, a white light-emitting device superior in color rendering properties is provided.

Yellow light is also emitted when the yellow light-emitting phosphor according to the present embodiment is excited with light in an ultraviolet region of 250 to 400 nm. Accordingly, a white light-emitting device can also be formed by combining the phosphor according to the present embodiment with, for example, a phosphor that emits blue light by excitation with ultraviolet light and a light-emitting element such as an ultraviolet light-emitting diode. A fluorescence light-emitting layer in such a white light-emitting device may contain a phosphor that emits light having a peak in another wavelength range by excitation with ultraviolet light, as well as the yellow light-emitting phosphor of the present embodiment. Examples of the phosphor include a phosphor that emits red light by excitation with ultraviolet light, a phosphor that emits green light by excitation with ultraviolet light, and the like.

As described above, the phosphor of the present embodiment has favorable temperature characteristics and can emit yellow light with a wide half-width emission spectrum with high efficiency. A white light-emitting device having excellent luminescence properties can be provided using a few kinds of phosphors by combining such a yellow light-emitting phosphor of the present embodiment with a light-emitting element that emits light having a luminescence peak in a wavelength range of 250 to 500 nm.

EXAMPLES

Specific examples of the phosphor and the light-emitting device are described as follows.

[Example 1]

First, $Sr_3N_2$, $CeO_2$, $Si_3N_4$, and AlN were prepared as a Sr-containing raw material, a Ce-containing raw material, a Si-containing raw material, and an Al-containing raw material, and were each weighed in a vacuum glove box. The masses of blended $Sr_3N_2$, $CeO_2$, $Si_3N_4$, and AlN were allowed to be 2.889 g, 0.155 g, 5.262 g, and 1.537 g, respectively. The blended raw material powders were dry-mixed in an agate mortar.

The resulting mixture was encased in a boron nitride (BN) crucible, and was fired in nitrogen atmosphere of at a pressure of 7.5 atmospheres at 1800°C for 2 hours. The fired product was taken out of the crucible and was crushed in an agate mortar. The fired product that had been crushed was re-encased in the crucible, fired at 1800°C for 4 hours, was then annealed at a cooling rate of 10°C/min until becoming at 1200°C, and was furnace-cooled when being at 1200°C or less. A series of such steps of taking-out, crushing, and firing was repeatedly performed twice, to thereby obtain a phosphor of Example 1.

The obtained phosphor, which was a powder with a yellow body color, was confirmed to emit yellow light when excited with black light.

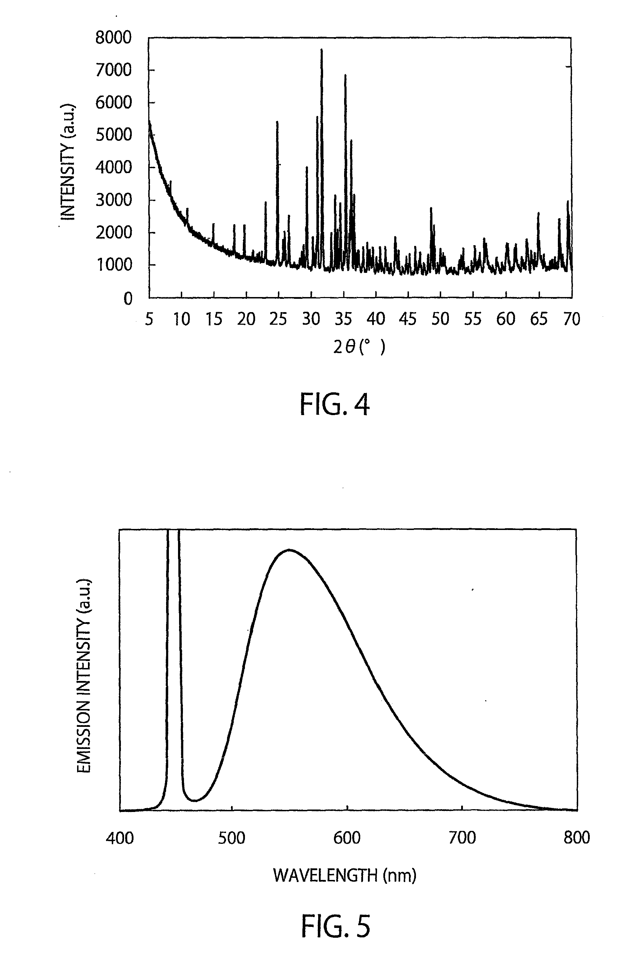

The XRD profile of the phosphor is shown in FIG. 4. The XRD profile was determined by the X-ray diffraction according to Bragg-Brendano method using a Cu-K$\alpha$ line. As shown in FIG. 4, peaks appear at diffraction angles ($2\theta$) of 15.05 to 15.25°, 23.03 to 23.23°, 24.87 to 25.07°, 25.70 to 25.90°, 25.97 to 26.17°, 29.33 to 29.53°, 30.92 to 31.12°, 31.65 to 31.85°, 33.02 to 33.22°, 33.59 to 33.79°, 34.35 to 34.55°, 35.20 to 35.60°, 36.02 to 36.22°, 36.55 to 36.75°, 37.20 to 37.40°, and 56.50 to 56.70°.

FIG. 5 shows the emission spectrum of the phosphor excited with light having a wavelength 450nm dispersed from a xenon lamp. In FIG. 5, emitted light having a narrow half-width at around 450 nm is not light emitted from the phosphor but reflected excitation light. A high emission intensity with a peak wavelength of 551 nm was confirmed. The half-width determined by using an instantaneous multichannel spectrometer was 122 nm. A half-width is one of the indices of the color rendering properties of white light emitted from a light-emitting device. Commonly, a wider half-width easily results in white light having higher color rendering properties. It is shown that white light having excellent color rendering properties is easily provided by using the phosphor of Example 1 because of its wide half-width.

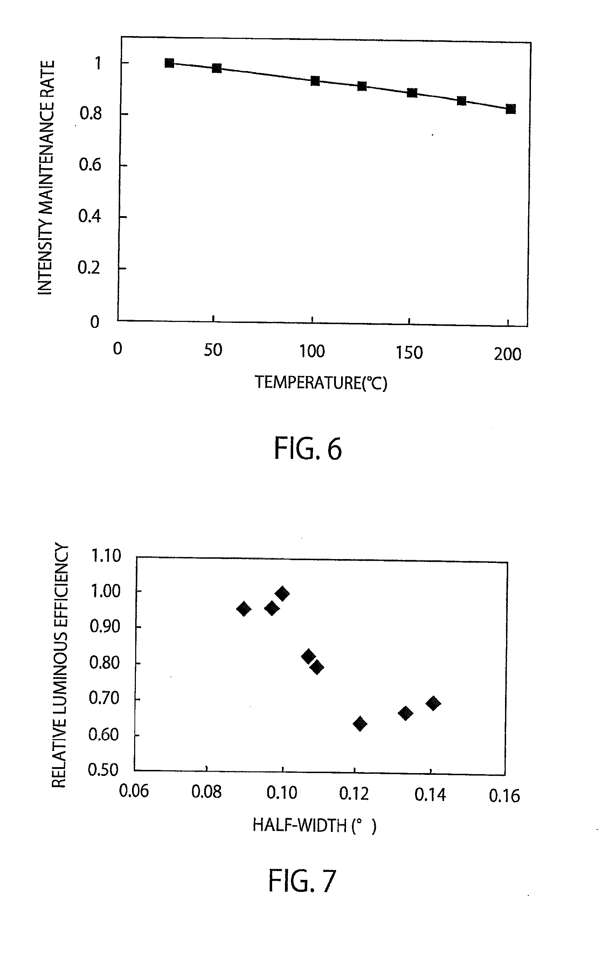

FIG. 6 shows the temperature characteristics of the phosphor. The temperature characteristics were determined as described below. The phosphor was heated by a heater, to obtain an emission intensity ($I_T$) at a predetermined temperature T°C. An instantaneous multichannel spectrometer was used for measuring the emission intensity. The emission intensity ($I_T$) was calculated from ($I_T/I_{25}$) $\times$ 100 using an emission intensity ($I_{25}$) at 25°C.

As shown in FIG. 6, an intensity maintenance rate of 0.88 or more is obtained even at 150°C, revealing that a reduction in emission intensity is low even if a temperature rises.

The relationship between the half-width of the X-ray diffraction pattern of the yellow phosphor synthesized in each of Examples and Comparative Examples and its luminous efficiency is summarized as shown in FIG. 7.

A light-emitting device having a configuration illustrated in FIG. 3 was produced using the phosphor of the present example.

An AlN substrate measuring 8 mm per side in which a p-electrode and an n-electrode (not illustrated) were formed in a predetermined region was prepared as an insulating substrate 301 with heat radiation characteristics. As a light-emitting element 302, a light-emitting diode having an emission peak wavelength of 460nm was joined onto the substrate by soldering. One electrode in the light-emitting element 302 was disposed on its bottom surface and was electrically connected to the n-electrode of the AlN substrate 301. The other electrode in the light-emitting element 302 was connected, through a gold wire 303, to the p-electrode (not illustrated) on the AlN substrate 301.

An internal transparent resin layer 304, a fluorescence light-emitting layer 305, and an external transparent resin layer 306 were sequentially formed in a dome shape on the light-emitting element 302, to produce the light-emitting device of the present example. Silicone resin was used as the material of the internal transparent resin layer 304, which was formed by a dispenser. A transparent resin containing 50 mass% of the phosphor of the present example was used for forming the fluorescence light-emitting layer 305. The transparent resin used was silicone resin. Furthermore, silicone resin similar to the silicone resin used in the internal transparent resin layer 304 was used for forming the external transparent resin layer 306 on the fluorescence light-emitting layer 305.

When the light-emitting device was mounted in an integrating sphere and was driven at 20 mA and 3.3 V, a color temperature of 6300 K, a light flux efficiency of 180 lm/W, and Ra = 76 were exhibited. The color temperature, the light flux efficiency, and Ra were obtained with an instantaneous multichannel spectrometer.

A white light-emitting device of the present embodiment was obtained by combining the phosphor of the present example with a blue LED with an emission peak wavelength of 460 nm. Such a white iight-emitting device can allow a white LED for high power with high luminous efficiency and high color rendering properties to be obtained.

[Examples 2 to 3 and Comparative Examples 1 to 5]

The phosphors of Examples 2 to 3 and Comparative Examples 1 to 5 were obtained by the same technique as in Example 1 except that the composition was changed as listed in Table 2 below and that the cooling rate in cooling from a firing temperature to 1200°C was changed. The compositions were analyzed by inductively coupled plasma (ICP).

Table 2

| | Sr | Ce | Si (10-z) | Al (z) | O (u) | N (w) | Al-O (z-u) | O+N (u+w) | Cooling rate (°C/min) |
|---|---|---|---|---|---|---|---|---|---|
| Example 1 | 1.85 | 0.09 | 7.53 | 2.47 | 0.45 | 13.91 | 2.02 | 14.36 | 10 |
| Example 2 | 1.84 | 0.09 | 7.52 | 2.48 | 0.42 | 13.83 | 2.06 | 14.25 | 10 |
| Example 3 | 1.94 | 0.06 | 7.55 | 2.45 | 0.47 | 13.62 | 1.98 | 14.09 | 2 |
| Comparative Example 1 | 1.73 | 0.07 | 7.72 | 2.28 | 0.49 | 13.42 | 1.79 | 13.91 | 15 |
| Comparative Example 2 | 1.47 | 0.07 | 7.70 | 2.30 | 0.33 | 13.47 | 1.97 | 13.80 | 15 |
| Comparative Example 3 | 1.30 | 0.07 | 6.95 | 3.05 | 0.28 | 13.25 | 2.77 | 13.53 | 15 |
| Comparative Example 4 | 1.56 | 0.06 | 6.93 | 3.07 | 0.24 | 12.97 | 2.83 | 13.21 | 15 |
| Comparative Example 5 | 1.68 | 0.07 | 7.74 | 2.26 | 0.47 | 13.42 | 1.80 | 13.89 | 15 |

The phosphors of Examples 2 to 3, both of which were powders with yellow body colors, were confirmed to emit yellow light when excited with black light. In the XRD patterns of the phosphors, ten strongest peaks in each of the phosphors belonged to any of diffraction angles ($2\theta$) of 15.05 to 15.25°, 23.03 to 23.23°, 24.87 to 25.07°, 25.97 to 25.90°, 29.33 to 29.53°, 30.92 to 31.12°, 31.65 to 31.85°, 33.02 to 33.22°, 33.59 to 33.79°, 34.35 to 34.55°, 35.20 to 35.60°, 36.02 to 36.22°, 36.55 to 36.75°, 37.20 to 37.40°, and 56.50 to 56.70°.

The half-widths of the peaks with the diffraction peak positions $2\theta$ in a range of 35.2 to 35.6 and the luminescence properties of the phosphors of Examples 2 to 3 and the phosphors of Comparative Examples 1 to 5 were investigated. The results as well as the half-width and luminescence property of the phosphor of Example 1 were summarized as listed in Table 3. The relative luminous efficiencies in Table 3 are shown assuming that the emission intensity in Example 2 is 1.

Table 3

| | Half-width (°) | Relative luminous efficiency |
|---|---|---|
| Example 1 | 0.0891 | 0.96 |

(continued)

|  | Half-width (°) | Relative luminous efficiency |
| --- | --- | --- |
| Example 2 | 0.0993 | 1.00 |
| Example 3 | 0.0965 | 0.96 |
| Comparative Example 1 | 0.1334 | 0.67 |
| Comparative Example 2 | 0.1405 | 0.70 |
| Comparative Example 3 | 0.1089 | 0.80 |
| Comparative Example 4 | 0.1067 | 0.83 |
| Comparative Example 5 | 0.1215 | 0.64 |

As listed in Table 3 described above, all of the phosphors of Examples 1 to 3 have high luminous efficiencies of 0.90 or more although having luminescence peaks in a wavelength range of 544 to 555 nm. In contrast, the phosphors of Comparative Examples 1 to 5 have luminous efficiencies of 0.64 to 0.83 and exhibit insufficient brightnesses compared to those of the phosphors of Examples.

The temperature characteristics of the phosphors of Examples 2 to 3 were also investigated by the same technique as described above. All of the phosphors of Examples 1 to 3 had intensity maintenance rates at 150°C of 0.81 or more and were confirmed to have favorable temperature characteristics similarly to that of Example 1.

As listed in Table 2 described above, all of the phosphors of Examples 1 to 3 had values of x, y, z, u, and w in specified ranges, had predetermined compositions, were able to emit yellow light with wide half-width emission spectra with high efficiency, and moreover had favorable temperature characteristics. In contrast, the phosphors of Comparative Examples 1 to 5, which had cooling temperatures exceeding 10°C/min, had low luminous efficiencies.

The X-ray diffraction measurement of the phosphors of Comparative Examples 1 to 5 was performed. As a result, in the phosphors of Comparative Examples, the half-widths were values exceeding 0.10°as listed in Table 3 although peaks existed in diffraction angle ($2\theta$) n ranges of 15.05 to 15.25°, 23.03 to 23.23°, 24.87 to 25.07°, 25.70 to 25.90°, 25.97 to 26.17°, 29.33 to 29.53°, 30.92 to 31.12°, 31.65 to 31.85°, 33.02 to 33.22°, 33.59 to 33.79°, 34.35 to 34.55°, 35.20 to 35.60°, 36.02 to 36.22°, 36.55 to 36.75°, 37.20 to 37.40°, and 56.50 to 56.70°.

Specifically, Comparative Example 2 had an XRD diffraction half-width that was as great as around 0.14° but had a low luminous efficiency and was incapable of providing a light-emitting device with favorable luminous efficiency even when combined with a blue light-emitting diode.

In accordance with the embodiment of the present invention, there is provided the phosphor that has favorable luminous efficiency and can emit yellow light with a wide half-width emission spectrum with high efficiency. When the yellow light-emitting phosphor of the present embodiment is combined with a blue LED, a white light-emitting device having excellent color rendering properties and favorable luminescence properties can be obtained. The combination of the yellow light-emitting phosphor with a green phosphor that emits light in a wavelength range of 490 to 550 nm and a red phosphor that emits light in a wavelength range of 600 nm to 660 nm can allow a white light-emitting device having further excellent color rendering properties to be obtained.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fail within the scope and spirit of the invention.

## Claims

1.    A phosphor, exhibiting a luminescence peak in a wavelength range of 500 to 600 nm when excited with light having a luminescence peak within a wavelength range of 250 to 500 nm,
wherein said phosphor is represented by the following formula (1):

$$((Sr_pM_{1-p})_{1-x}Ce_x)_{2y}Al_zSi_{10-z}O_uN_w \quad (1)$$

wherein M is at least one of alkali metals or alkaline earth metals; and

$$0 \leq p \leq 1,$$

$$0 < x \leq 0.2,$$

$$0.8 \leq y \leq 1.1,$$

$$2 \leq z \leq 3.5,$$

$$0 < u \leq 1,$$

$$1.8 \leq z - u,$$

and

$$13 \leq u + w \leq 15$$

are satisfied; and
a half-width at a diffraction peak position 2θ in a range of 35.2 to 35.6°, detected in X-ray diffraction of the phosphor by Bragg-Brendano method using a Cu-Kα line, is 0.10°or less.

2. The phosphor according to claim 1, wherein M is at least one selected from Ba, Ca, and Mg.

3. The phosphor according to claim 1, comprising at least ten peaks at diffraction angles (2θ) of 15.05 to 15.25°, 23.03 to 23.23°, 24.87 to 25.07°, 25.70 to 25.90°, 25.97 to 26.17°, 29.33 to 29.53°, 30.92 to 31.12°, 31.65 to 31.85°, 33.02 to 33.22°, 33.59 to 33.79°, 34.35 to 34.55°, 35.20 to 35.60°, 36.02 to 36.22°, 36.55 to 36.75°, 37.20 to 37.40°, and 56.50 to 56.70° in X-ray diffraction according to Bragg-Brendano method using a Cu-Kα line.

4. A light-emitting device, comprising:

   a light-emitting element that emits light having a luminescence peak in a wavelength range of 250 to 500 nm; and
   a fluorescence light-emitting layer comprising a phosphor that receives light from the light-emitting element and emits yellow light, said yellow light-emitting phosphor comprising the phosphor according to claim 1.

5. The light-emitting device according to claim 4,
   wherein the fluorescence light-emitting layer further comprises a phosphor that emits green light and a phosphor that emits red light.

6. A method for producing the phosphor according to claim 1, comprising:

   a step of mixing a Sr-containing raw material selected from nitrides, silicides, carbides, carbonates, hydroxides, and oxides of Sr, a M-containing raw material selected from nitrides, carbides, carbonates, hydroxides, and oxides of M, an Al-containing raw material selected from nitrides, oxides, and carbides of Al, a Si-containing raw material selected from nitrides, oxides, and carbides of Si, and a Ce-containing raw material selected from chlorides, oxides, nitrides, and carbonates of Ce, to obtain a mixture;
   a step of firing the mixture; and
   a step of cooling a fired product at a cooling rate of 10°C/min or less after the firing.

7. The method according to claim 6, wherein said mixture is fired at 1500 to 2000°C under a pressure of 5 atmospheres or more.

8. The method according to claim 6, wherein said mixture is fired in nitrogen atmosphere.

9. The method according to claim 6, wherein the cooling rate is less than 10°C/min until a temperature of atmosphere becomes 1300°C when the fired product is cooled after the firing.

10. The method according to claim 6, further comprising:

a step of cleaning the fired product after the firing.

11. A phosphor, produced by the method comprising:

a step of mixing a Sr-containing raw material selected from nitrides, silicides, carbides, carbonates, hydroxides, and oxides of Sr, a M-containing raw material selected from nitrides, carbides, carbonates, hydroxides, and oxides of M, an Al-containing raw material selected from nitrides, oxides, and carbides of Al, a Si-containing raw material selected from nitrides, oxides, and carbides of Si, and a Ce-containing raw material selected from chlorides, oxides, nitrides, and carbonates of Ce, to obtain a mixture;
a step of firing the mixture; and
a step of cooling a fired product at a cooling rate of 10°C/min or less after the firing.

FIG. 1A

FIG. 1B

FIG. 1C

205     209

211   210

204

203

207

208

201

206

202

200

# FIG. 2

306

304

307

303

305

308

301

302

# FIG. 3

FIG. 4

FIG. 5

FIG. 6

FIG. 7

Europäisches
Patentamt

European
Patent Office

Office européen
des brevets

# EUROPEAN SEARCH REPORT

Application Number

EP 15 18 2329

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 778 211 A1 (TOSHIBA KK [JP]) 17 September 2014 (2014-09-17) * paragraph [0065] - paragraph [0067] * * paragraph [0046] * * paragraph [0048] * * paragraph [0052] * ----- | 1-11 | INV. H01L33/50 C09K11/77 |
| X | US 2013/241387 A1 (FUKUDA YUMI [JP] ET AL) 19 September 2013 (2013-09-19) * examples 1-17 * * paragraph [0072] - paragraph [0078] * * paragraph [0080] * ----- | 1-11 | |
| X | WO 2013/137436 A1 (TOSHIBA KK [JP]; TOSHIBA MATERIALS CO LTD [JP]) 19 September 2013 (2013-09-19) * paragraph [0124] - paragraph [0133]; example 1 * ----- | 1-11 | |
| X | EP 2 775 539 A2 (TOSHIBA KK [JP]) 10 September 2014 (2014-09-10) * see "Example" * ----- | 1-11 | TECHNICAL FIELDS SEARCHED (IPC) |
| X | EP 2 711 410 A1 (TOSHIBA KK [JP]) 26 March 2014 (2014-03-26) * claims 1,4,7; example 1 * ----- | 1-11 | H01L |

The present search report has been drawn up for all claims

| Place of search | Date of completion of the search | Examiner |
|---|---|---|
| The Hague | 1 February 2016 | Poole, Robert |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 15 18 2329

This annex lists the patent family members relating to the patent documents cited in the above-mentioned European search report.
The members are as contained in the European Patent Office EDP file on
The European Patent Office is in no way liable for these particulars which are merely given for the purpose of information.

01-02-2016

| Patent document cited in search report | | Publication date | Patent family member(s) | | Publication date |
|---|---|---|---|---|---|
| EP 2778211 | A1 | 17-09-2014 | CN 104046352 A | | 17-09-2014 |
| | | | EP 2778211 A1 | | 17-09-2014 |
| | | | JP 2014177592 A | | 25-09-2014 |
| | | | KR 20140113350 A | | 24-09-2014 |
| | | | TW 201504391 A | | 01-02-2015 |
| | | | US 2014265819 A1 | | 18-09-2014 |
| US 2013241387 | A1 | 19-09-2013 | CN 103113895 A | | 22-05-2013 |
| | | | EP 2597129 A1 | | 29-05-2013 |
| | | | JP 5762929 B2 | | 12-08-2015 |
| | | | JP 2013104041 A | | 30-05-2013 |
| | | | KR 20130054123 A | | 24-05-2013 |
| | | | KR 20140130078 A | | 07-11-2014 |
| | | | TW 201335336 A | | 01-09-2013 |
| | | | US 2013241387 A1 | | 19-09-2013 |
| WO 2013137436 | A1 | 19-09-2013 | CN 104204134 A | | 10-12-2014 |
| | | | EP 2837669 A1 | | 18-02-2015 |
| | | | JP WO2013137436 A1 | | 03-08-2015 |
| | | | US 2015030855 A1 | | 29-01-2015 |
| | | | WO 2013137436 A1 | | 19-09-2013 |
| EP 2775539 | A2 | 10-09-2014 | CN 104037308 A | | 10-09-2014 |
| | | | EP 2775539 A2 | | 10-09-2014 |
| | | | JP 2014175378 A | | 22-09-2014 |
| | | | KR 20140110735 A | | 17-09-2014 |
| | | | TW 201442295 A | | 01-11-2014 |
| | | | US 2014252391 A1 | | 11-09-2014 |
| EP 2711410 | A1 | 26-03-2014 | CN 103666470 A | | 26-03-2014 |
| | | | EP 2711410 A1 | | 26-03-2014 |
| | | | JP 5746672 B2 | | 08-07-2015 |
| | | | JP 2014065797 A | | 17-04-2014 |
| | | | KR 20140039956 A | | 02-04-2014 |
| | | | US 2014084782 A1 | | 27-03-2014 |

EPO FORM P0459

For more details about this annex : see Official Journal of the European Patent Office, No. 12/82